Europäisches Patentamt

European Patent Office

Office européen des brevets

(19)

(11) **EP 1 471 167 A2**

(12) **EUROPEAN PATENT APPLICATION**

(43) Date of publication:
　　27.10.2004　Bulletin 2004/44

(51) Int Cl.$^7$: **C23C 18/16**, C23C 18/28

(21) Application number: **04252270.6**

(22) Date of filing: **16.04.2004**

(84) Designated Contracting States:
　　**AT BE BG CH CY CZ DE DK EE ES FI FR GB GR
　　HU IE IT LI LU MC NL PL PT RO SE SI SK TR**
　　Designated Extension States:
　　**AL HR LT LV MK**

(30) Priority:　**23.04.2003　JP 2003117828**

(71) Applicant: **Shinko Electric Industries Co., Ltd.
　　Nagano-shi, Nagano 381-2287 (JP)**

(72) Inventor: **Murayama, Kei
　　Shinko Electric Industries Co., Ltd.
　　Nagano-shi, Nagano 381-2287 (JP)**

(74) Representative: **Fenlon, Christine Lesley
　　Haseltine Lake,
　　Imperial House,
　　15-19 Kingsway
　　London WC2B 6UD (GB)**

(54)　**Electroless plating method**

(57)　　An electroless plating method of the present invention includes the steps of preparing a substrate (15) having an insulating body (10) and a conductive pattern (12) formed thereon, adhering a catalytic metal (14) serving as a catalyst of an electroless plating onto the insulating body (10) and the conductive pattern (12), forming selectively a protection film (16) or an oxidizing agent used to oxidize the catalytic metal on the catalytic metal (14) in a space portion (S) between the conductive pattern (12), and forming selectively a metal layer (18) on the conductive pattern (12) by the electroless plating.

FIG. 2A

EP 1 471 167 A2

# FIG. 2D

**Description**

The present invention relates to an electroless plating method and, more particularly, an electroless plating method that is applicable in the step of plating selectively a metal layer on conductive patterns.

In the steps of a previously-proposed technique for manufacturing a wiring substrate, etc., there is a step of forming selectively a gold layer on conductive patterns by electroless plating. For example, in a wiring substrate on which electronic parts are packaged, normally electrodes are formed of copper. Thus, in many cases a metal layer such as a nickel layer, gold layer, or the like is formed selectively on the copper electrodes to enhance reliability of the connection to the electronic parts.

In such a wiring substrate, the solder resist film having opening portions on the copper electrodes, surfaces of which are subjected to the catalytic activating process, is formed. Then, a metal layer such as a nickel layer, gold layer, or the like is formed on the copper electrodes, which are exposed from the opening portions of the solder resist film, by the electroless plating.

In recent years, finer patterns of the wirings on the wiring substrate are advanced with miniaturization and higher performance of the electronic parts, and thus a narrower electrode pitch on the wiring substrate is intended. If a pitch of the copper electrodes on the wiring substrate is narrowed (e.g., almost 60 μm or less), it becomes difficult to form the solder resist film, in which the opening portions are provided on the copper electrodes respectively, with good precision.

Accordingly, the nickel layer and the gold layer must be formed selectively on the copper electrodes by the electroless plating in a state that the solder resist is not formed in the area, in which the copper electrodes are arranged, of the wiring substrate. In this case, palladium as the catalyst is attached onto the copper electrodes and the insulating body on the wiring substrate, and then the plating is applied selectively onto the copper electrodes that are activated by the catalyst.

However, because palladium is attached onto the insulating body, such insulating body is slightly plated. Therefore, such problems exist that the copper electrodes are ready to short-circuit electrically particularly in portions in which space portions between the copper electrodes are narrow, and thus production yield of the wiring substrate is lowered.

For this reason, a method of forming selectively the metal layer on the electrodes formed at a narrow pitch by the electroless plating with good yield is desired earnestly.

In this case, in Patent Application Publication (KOKAI) 2002-26491 (Patent Literature 1), it is set forth that the electroless plating process is carried out by supplying an electroless plating solution to surfaces of the conductive patterns by using the ink jet method. Nevertheless, the catalytic process as the pre-process of the electroless plating is not considered at all, and thus this publication does not suggest the present invention.

Accordingly, it is desirable to provide an electroless plating method capable of forming a metal layer on conductive patterns of a narrow pitch by electroless plating with good yield.

According to an embodiment of the present invention there is provided an electroless plating method which comprises the steps of preparing a substrate having an insulating body and a conductive pattern formed on the insulating body; adhering a catalytic metal serving as a catalyst of an electroless plating onto the insulating body and the conductive pattern; forming selectively a protection film or an oxidizing agent used to oxidize the catalytic metal on the catalytic metal in a space portion S between the conductive pattern; and forming selectively a metal layer on the conductive pattern by the electroless plating.

An embodiment of the present invention is created to prevent the electrical short-circuit between the conductive patterns caused by applying the plating to space portions between the conductive patterns, when the metal layer is formed selectively on the conductive patterns formed on the insulating body by the electroless plating.

In an embodiment of the present invention, the catalytic metal (e.g., palladium) serving as the catalyst of the electroless plating is adhered onto the insulating body and the conductive patterns. Then, the protection film is formed on the catalytic metal in these space portions between the conductive patterns or the oxidizing agent for oxidizing the space portions between the conductive patterns is coated selectively, to bring the catalytic metal in the portions into its inactive state. Then, the metal layer (e.g., nickel layer, copper layer, or the like) is formed selectively on the conductive patterns by the electroless plating.

When doing this, the catalytic metal is not exposed or the catalytic metal becomes inactive, in the space portions between the conductive patterns. Therefore, the electroless plating is not applied to the space portions between the conductive patterns. As a result, generation of the mutual electrical short-circuit between the patterns can be prevented even in fine conductive patterns.

In one preferred mode of the present invention, the step of forming selectively the protection film or the oxidizing agent is carried out by an ink jet method. Also, the conductive pattern is arranged in a state that the space portion between the conductive patterns has a plurality of different dimensions, and the protection film or the oxidizing agent is formed selectively in portions, which are smaller than a predetermined dimension, out of the space portion between the conductive patterns.

In the preferred mode of the present invention, in case the plating is applied like the scatter to the space portions between the conductive patterns, the protection film (or the oxidizing agent) can be formed selectively only on necessary portions out of the space portions between the conductive patterns by the ink jet method by identifying portions (narrow width portions) in which the conductive patterns are electrically short-circuited mutually and portions (wide width portions) in which the conductive patterns are not short-circuited mutually by applying the plating.

Therefore, the protection film (or the oxidizing agent) can be formed in a very short time. As a result, the electrical short-circuit between the conductive patterns can be prevented at a low cost, and thus production yield of the wiring substrate can be improved.

An embodiment of the present invention is related to an electroless plating method which comprises the steps of preparing a substrate having an insulating body and a conductive pattern formed on the insulating body; adhering selectively a catalytic metal serving as a catalyst of an electroless plating onto the conductive pattern; and forming selectively a metal layer on the conductive pattern by the electroless plating.

In an embodiment of the present invention, in place of formation of the protection film (or the oxidizing agent) on the space portions between the conductive electrodes, the catalytic metal is deposited selectively only on the conductive patterns. For example, the activation solution is coated selectively on the conductive patterns by the electroless plating, and then the catalytic metal is deposited selectively by the oxidation-reduction reaction and adhered onto the conductive patterns.

If doing this, the electroless plating is applied selectively only to the conductive patterns because the catalytic metal does not exist in the space portions between the conductive patterns. Thus, generation of the electrical short-circuit between the conductive patterns can be prevented.

Reference will now be made, by way of example, to the accompanying drawings, in which:

FIGS.1A to 1C are sectional views showing the problem caused when the electroless plating is applied onto conductive patterns formed at a narrow pitch;
FIGS.2A to 2D are sectional views showing an electroless plating method of a first embodiment of the present invention;
FIGS.3A to 3D are sectional views showing an electroless plating method of a second embodiment of the present invention; and
FIG.4 is a schematic view showing an ink jet apparatus used in the electroless plating method of embodiments of the present invention.

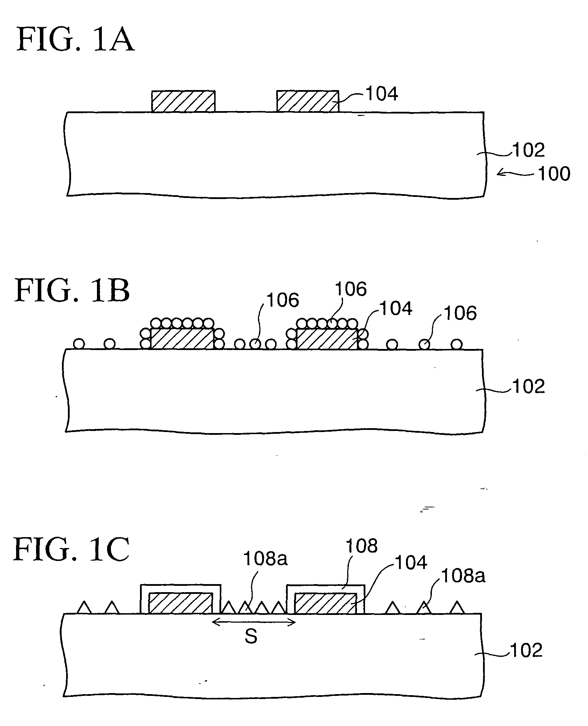

Prior to the explanation of embodiments of the present invention, the problem caused when the electroless plating is applied onto conductive patterns formed at a narrow pitch will be explained hereunder. FIGS.1A to 1C are sectional views showing the problem caused when the electroless plating is applied to conductive patterns formed at a narrow pitch.

As shown in FIG.1A, first a substrate 100 having a structure in which copper (Cu) electrodes 104 are formed on an insulating body 102 is prepared. Then, as shown in FIG.1B, the substrate 100 is cleaned, and then the substrate 100 is dipped into a tin chloride ($SnCl_2$) solution and then dipped into a palladium chloride ($PdCl_2$) solution.

Accordingly, as shown in FIG.1B, Pd 106 is deposited and adhered on the Cu electrodes 104 by the oxidation-reduction reaction, which exerts strong catalytic action on the electroless plating. At this time, the insulating body 102 itself has the weak catalytic activity, nevertheless Pd 106 is also adhered onto the insulating body 102.

Then, as shown in FIG.1C, a Ni layer 108 is formed selectively on the Cu electrodes 104 by dipping the substrate 100 into the electroless plating solution for nickel (Ni). At this time, since the Pd 106 is also adhered onto the insulating body 102, the electroless plating is slightly applied to the insulating body 102 to form Ni particles 108a.

In particular, in case a space portion S between the Cu electrodes 104 is narrow (e.g., 30 μm or less), short-circuit between the Cu electrodes 104 occurs readily because of the influence of the Ni particles 108a formed on the insulating body 102. Thus, such a problem existed that a reduction in yield of the production is brought about.

Electroless plating methods of embodiments of the present invention can overcome the above problem.

(First Embodiment)

Embodiments of the present invention will be explained with reference to the accompanying drawings hereinafter.

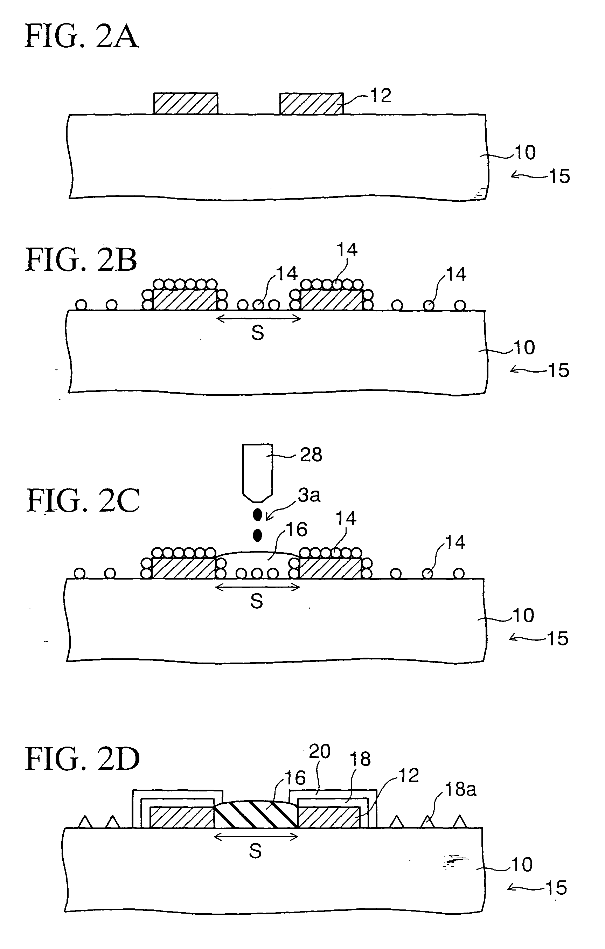

FIGS.2A to 2D are sectional views showing an electroless plating method of a first embodiment of the present invention. In the electroless plating method of a first embodiment of the present invention, first, as shown in FIG.2A, a substrate 15 having a structure in which Cu electrodes 12 as an example of the conductive patterns are formed on an insulating body 10 is prepared. For example, this substrate 15 is the wiring substrate on which electronic parts are packaged, and connection pads of the electronic parts are connected to the Cu electrodes 12 on the substrate 15. In this case, in order to improve reliability of connection to the electronic parts, a Ni layer and a gold layer are formed on the Cu electrodes 12 by the electroless plating.

The electroless plating method of an embodiment of the present invention can be applied to the step of forming selectively various metal layers on the conductive patterns. In the present embodiment, explanation is made with the step of forming the Ni layer on the Cu electrodes 12 taken as an example.

Then, the substrate 15 is cleaned with ethanol to degrease, and then is dipped into a 50 % hydrochloric acid (HCl) solution to apply the soft etching to surfaces of the substrate 15. Then, the substrate 15 is dipped into a tin chloride (II)($SnCl_2$) solution (sensitization solution) to adhere Sn (II) ions onto the substrate 15.

Then, the substrate 15 is dipped into a palladium chloride ($PdCl_2$) solution (activation solution). Accordingly, as shown in FIG.2B, the oxidation-reduction reaction advances based on a following reaction formula (1) to reduce (activate) Pd (II) ions, and thus Pd 14 (catalytic metal) is deposited and adhered onto the Cu electrodes 12.

$$Sn(II)+Pd(II) \rightarrow Sn(IV)+Pd \text{ (catalyst nucleus)} \tag{1}$$

In this manner, the surfaces of the Cu electrodes 12 are covered with the Pd 14 to exhibit the strong catalytic action on the electroless plating.

At this time, as described above, although the insulating body 10 itself has the weak catalytic activity, the Pd 14 is adhered slightly onto the insulating body 10. Therefore, as described above, the plating is slightly applied to the space portions S between the Cu electrodes 12, so that it is possible that the Cu electrodes 12 are electrically short-circuited mutually.

One of the features of the present embodiment is that the electroless plating should not be applied onto at least the space portions S, in which the possibility of generation of the electrical short-circuit exists, between the Cu electrodes 12. Thus, as shown in FIG.2C, a protection film 16 is formed selectively on the space portions S (e.g., portions of 30 µm or less) between the Cu electrodes 12 in the subsequent step. As the protection film 16, an insulating film such as a resist film, a polyimide film, or the like is employed.

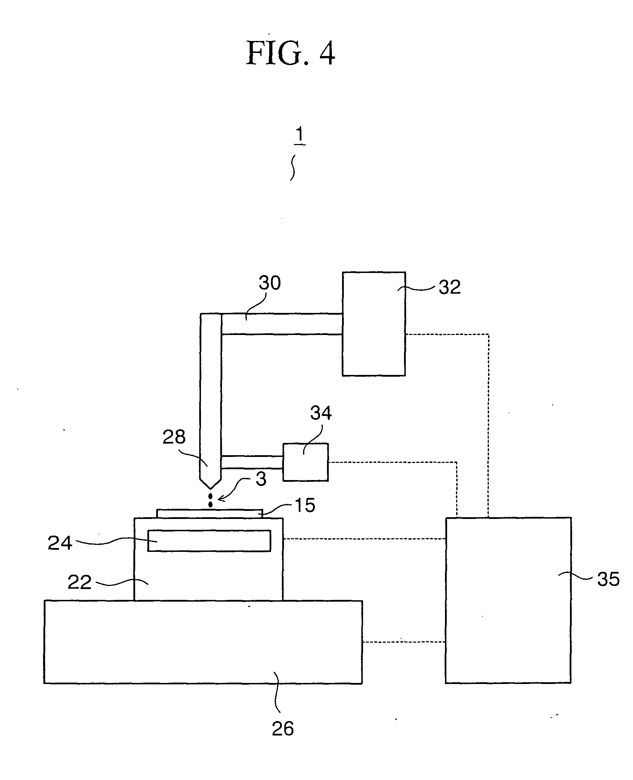

In the step of forming the protection film 16, preferably the ink jet method is employed. FIG.4 is a schematic view showing an ink jet apparatus used in the present embodiment. As shown in FIG.4, an ink jet apparatus 1 according to the present embodiment has a stage 22 on which the substrate 15 is loaded. This stage 22 is connected to a stage moving means 26 for moving the stage 22. Accordingly, the stage 22 can be moved to any position in the horizontal direction containing X-Y directions.

The substrate 15 is fixed onto the stage 22 by a chucking means (not shown) such as a vacuum chuck, or the like. Also, a heating means 24 such as a heater, or the like for heating the substrate 15 is provided to the stage 22, so that the substrate 15 can be heated.

A coating means 28 containing a plurality of nozzles that spray a liquid 3 onto the substrate 15 to coat it is arranged over the stage 22. The coating means 28 is connected to a liquid supplying portion 32 via a piping 30. Also, a nozzle controlling means 34 is connected to the coating means 28 to select the nozzle of the coating means 28 and control the spray characteristics, etc.

In addition, the ink jet apparatus 1 has a controller 35. This controller 35 is connected to the stage moving means 26, the heating means 24, the liquid supplying portion 32, and the nozzle controlling means 34. Thus, positioning of the position of the substrate 15 on which the liquid 3 is coated, the spray characteristics of the liquid 3 from the coating means 28, etc. are controlled by the controller 35.

As the above coating means 28, the bubble jet system in which the liquid is sprayed from the nozzle by generating the bubble in the liquid filled in the nozzle by virtue of a heat generating body, or the piezo driving system in which the liquid is sprayed from the nozzle by using the piezo element is employed.

The substrate 15 to which the above catalytic process is applied is loaded on the stage 22 of such ink jet apparatus 1. Then, the substrate 15 is fixed by the chucking means. Then, as shown in FIG.2C, while moving the stage 22 in the horizontal direction or in a state that the stage 22 is fixed, a coating liquid 3a such as resist, polyimide, or the like is coated selectively on the space portions S between the Cu electrodes 12 on the substrate 15 by the coating means 28 to form a coating film. Then, a resin film is formed by heating the coating film by means of the heating means 24 to obtain the protection film 16.

The protection film 16 can be formed on the space portions S between the Cu electrodes 12 in a short time by using such ink jet apparatus 1 without the photolithography.

Then, the electroless plating solution is prepared to form the Ni layer by the electroless plating. As the electroless plating solution, a solution in which sodium hypophosphite ($NaH_2PO_2$) as a reducing agent, ammonium sulfate (($NH_4)_2SO_4$) as a buffer agent, sodium citrate ($C_3H_4(OH) (CO_2Na)_3$) as a complexing agent, and nickel sulfate ($NiSO_4$) as a metallic salt are mixed is employed.

Then, as shown in FIG.2D, a Ni layer 18 (metal layer) is formed selectively on the Cu electrodes 12 by dipping the substrate 15, which is subjected to the catalytic process, in the above electroless plating solution. At this time, Ni is deposited based on a reaction formula (2) and thus the Ni layer 18 is formed.

$$Ni_2^+ + H_2PO_2^- + 3OH^- \rightarrow Ni + HPO_3^{2-} + 2H_2O \qquad (2)$$

Also, since the protection film 16 is coated on the space portions S between the Cu electrodes 12 at this time, the Pd 14 as the catalyst of the electroless plating is not exposed. Therefore, the Ni plating is not applied to the space portions S between the Cu electrodes 12.

In this fashion, in a state that the protection film 16 is coated on at least the portions, in which the possibility of generation of the electrical short-circuit exists, out of the space portions S between the Cu electrodes 12 not to expose the Pd 14, the Ni layer 18 is formed on the Cu electrodes 12 by the electroless plating. Therefore, even though the Cu electrodes 12 are arranged at a narrow pitch (e.g., 60 µm (line:space=30 µm:30 µm) or less), such a trouble is not caused that the Cu electrodes 12 are electrically short-circuited mutually. Thus, production yield of the products can be improved.

In this case, Ni particles 18a are plated on the insulating body 10 on which the protection film 16 is not formed. However, the Cu electrodes 12 are not electrically short-circuited mutually because the space portions between the Cu electrodes 12 are wide.

Then, the Ni layer 18 and a gold layer 20 are formed selectively on the Cu electrodes 12 on the substrate 15 by dipping the substrate 15 into the electroless plating solution for gold.

As a variation the present embodiment, in place of formation of the protection film 16 on the space portions S between the Cu electrodes 12, an oxidizing agent having a function of oxidizing the deposited Pd 14 conversely may be coated on the space portions S between the Cu electrodes 12 by the ink jet apparatus 1. Accordingly, the Pd 14 deposited by reducing (activating) the Pd ions is oxidized conversely to become its inactive state.

Accordingly, the Pd 14 in the portions on which the oxidizing agent is coated does not exhibit the catalytic action on the electroless plating. Therefore, the oxidation-reduction reaction based on the above reaction formula (2) is suppressed, and thus the Ni plating is not applied to the space portions S between the Cu electrodes 12. As such oxidizing agent, for example, $H_2SO_4$ or a mixed solution consisting of $H_2SO_4$ and HCl, or the like is employed.

Also, in the present embodiment, such a mode is exemplified that the protection film 16 is not coated on the portions in which widths of the space portions S between the Cu electrodes 12 are set wide (portions in which the Cu electrodes 12 are not electrically short-circuited mutually even when the Ni particles are formed). In this event, the protection film 16 may be formed on the overall insulating body 10 on the portions except the Cu electrodes 12. In this case, since the plating is applied selectively only onto the Cu electrodes 12 to form the Ni layer 18, production yield of the products can be improved further.

As described above, in the electroless plating method of the present embodiment, first the Pd 14 as the catalyst of the electroless plating is adhered onto the insulating body 10 and the Cu electrodes 12, and then the protection film 16 is formed on the space portions S between the Cu electrodes 12 (or the oxidizing agent is coated). Then, the Ni layer 18 is formed selectively on the Cu electrodes 12 by the electroless plating.

As a result, since the Ni plating is not applied to the space portions S between the Cu electrodes 12, the Ni layer 18 can be formed selectively on the Cu electrodes 12 formed at a narrow pitch with good yield. In this way, in the present embodiment, even though fine conductive patterns having a pitch of almost 60 µm or less, on which it is difficult to form the solder resist film, are employed, the metal film can be formed on such conductive patterns by the electroless plating as a simple method with good yield.

In this case, a mode is exemplified in which the technical idea of the present invention is applied to the step of electroless-plating the Ni layer 18 on the Cu electrodes 12. Also, an embodiment of the present invention can be applied to the electroless plating step for various metals such as copper, gold, silver, cobalt, tin, palladium, etc., which are formed on the conductive patterns by the electroless plating using the catalytic action of the catalytic metal.

(Second Embodiment)

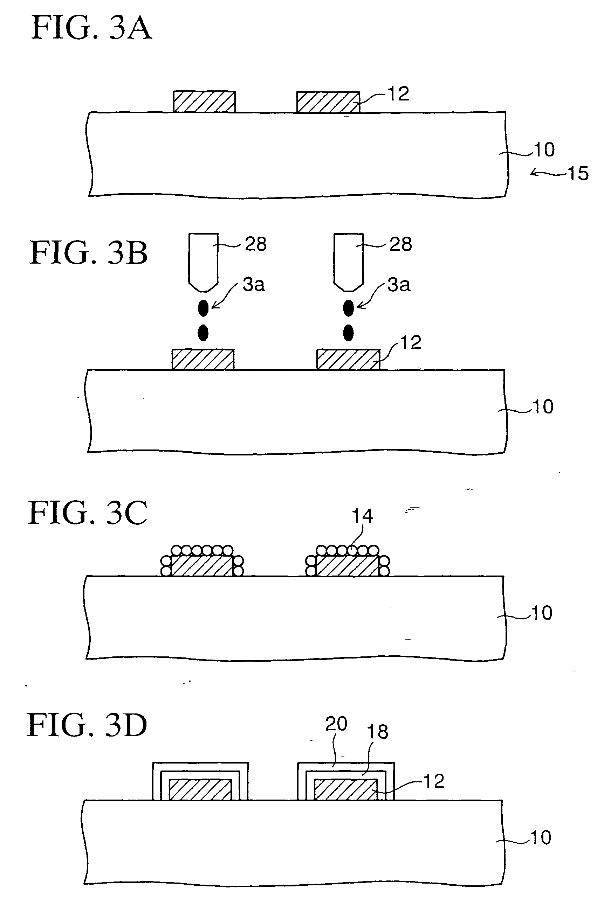

FIGS.3A to 3D are sectional views showing an electroless plating method of a second embodiment of the present invention. A difference of the second embodiment from the first embodiment is that Pd is adhered selectively to Cu electrodes only. Detailed explanation of the similar steps to those in the first embodiment will be omitted herein.

In the electroless plating method of the second embodiment of the present invention, as shown in FIG.3A, like the first embodiment, first the substrate 15 having the structure in which the Cu electrodes 12 are formed on the insulating body 10 is prepared. Then, the substrate 15 is cleaned with ethanol, and then is dipped into the 50 % hydrochloric acid (HCl) solution to apply the soft etching to surfaces of the substrate 15. Then, the substrate 15 is dipped into the tin chloride (II) (SnCl$_2$) solution to adhere the Sn (II) ions onto the substrate 15.

Then, as shown in FIG.3B, the coating liquid 3a formed of the palladium chloride (PdCl$_2$) solution is coated selectively on the Cu electrodes 12 by the foregoing ink jet apparatus 1. Thus, as shown in FIG.3C, the Pd 14 is deposited/adhered onto the surface of the Cu electrodes 12 by the oxidation-reduction reaction, which exhibits the strong catalytic action on the electroless plating.

The Pd 14 is deposited based on the reaction formula (1) explained in the first embodiment. In the second embodiment, the Pd 14 is deposited selectively and adhered only onto the Cu electrodes 12. Therefore, since the Pd 14 does not exist on the insulating body 10 in portions except the Cu electrodes 12, such portions do not exhibit the catalytic action on the electroless plating.

Then, as shown in FIG.3D, the substrate 15 is dipped into the electroless plating solution to form the Ni layer by the similar method to the first embodiment. Thus, the Ni layer 18 is formed selectively on the Cu electrodes 12. At this time, since the Pd 14 is not adhered onto the insulating body 10 in the portions except the Cu electrodes 12, the Ni plating is not applied to the insulating body 10 and thus the Ni layer 18 is formed selectively on the Cu electrodes 12. Then, the Au layer 20 is formed selectively on the Ni layer 18 by the electroless plating.

As a result, like the first embodiment, the Cu electrodes 12 are by no means electrically short-circuited mutually, and therefore the Ni layer 18 and the Au layer 20 can be formed on the Cu electrodes 12 with good yield.

In the second embodiment also, the present invention can also be applied to the electroless plating method for various metals, which is used to form selectively the metal film by adhering the catalytic metal on the conductive patterns.

The second embodiment can achieve the similar advantages to the first embodiment, and also can reduce a production cost rather than the first embodiment because the step of forming the protection film 16 is not required.

As described above, in an embodiment of the present invention, the catalytic metal serving as the catalyst of the electroless plating is adhered onto the insulating body and the conductive patterns, and then the protection film or the oxidizing agent is formed selectively on the catalytic metal in the space portions between the conductive patterns. Then, the metal layer is formed selectively on the conductive patterns by the electroless plating.

Accordingly, the catalytic metal is not exposed or the catalytic metal becomes inactive, in the space portions between the conductive patterns. Therefore, the electroless plating is not applied to the space portions between the conductive patterns. As a result, generation of the mutual electrical short-circuit between the patterns can be prevented even in the fine conductive patterns.

**Claims**

1. An electroless plating method comprising the steps of:

    preparing a substrate (15) having an insulating body (10) and a conductive pattern (12) formed on the insulating body (10);
    adhering a catalytic metal (14) serving as a catalyst of an electroless plating onto the insulating body (10) and the conductive pattern (12);
    forming selectively a protection film (16), or an oxidizing agent used to oxidize the catalytic metal on the catalytic metal (14) in a space portion S between the conductive pattern (12); and
    forming selectively a metal layer (18) on the conductive pattern (12) by the electroless plating.

2. An electroless plating method comprising the steps of:

    preparing a substrate (15) having an insulating body (10) and a conductive pattern (12) formed on the insulating body (10);
    adhering selectively a catalytic metal (14) serving as a catalyst of an electroless plating onto the conductive pattern (12); and
    forming selectively a metal layer (18) on the conductive pattern (12) by the electroless plating.

3. An electroless plating method according to claim 1, wherein the step of forming selectively the protection film (16) or the oxidizing agent is carried out by an ink jet method.

4. An electroless plating method according to claim 1, wherein the step of adhering the catalytic metal (14) onto the insulating body (10) and the conductive pattern (12) includes the step of coating an activating solution containing ions of the catalytic metal (14) to deposit the catalytic metal (14) by an oxidation-reduction reaction.

5. An electroless plating method according to claim 1, 3 or 4, wherein the conductive pattern (12) is arranged in a state that the space portion between the conductive patterns has a plurality of different dimensions, and the protection film (16) or the oxidizing agent is formed selectively in portions, which are smaller than a predetermined dimension, out of the space portion between the conductive patterns (12).

6. An electroless plating method according to claim 2, wherein the step of adhering selectively the catalytic metal (14) onto the conductive pattern (12) includes the step of coating selectively an activating solution containing ions of the catalytic metal (14) on the conductive pattern (12) by an ink jet method to deposit selectively the catalytic metal (14) on the conductive pattern (12) by an oxidation-reduction reaction.

7. An electroless plating method according to any one of claims 1, 3, 4 or 5, wherein the protection film (16) is a resist film or a polyimide film.

8. An electroless plating method according to any preceding claim, wherein the catalytic metal (14) is palladium, and the metal layer (18) formed by the electroless plating is a nickel layer or a copper layer.

FIG. 1A

~104

~102

←~100

FIG. 1B

106    106
          ~104    106

~102

FIG. 1C

108a    108    104    108a

S

~102

FIG. 2A

FIG. 2B

FIG. 2C

FIG. 2D

FIG. 3A

12

10

15

FIG. 3B

28

3a

28

3a

12

10

FIG. 3C

14

10

FIG. 3D

20  18

12

10

# FIG. 4